# EUROPEAN PATENT APPLICATION

(11) **EP 3 462 605 A1**
(43) Date of publication of application: **03.04.2019**
(21) Application number: 17194363.2
(22) Date of filing: 02.10.2017
(51) Int. Cl.: H02S 20/21, H02S 30/10

(54) **PHOTOVOLTAIC ROADWAY ASSEMBLY**

(71) Applicant: Nederlandse Organisatie voor toegepast- natuurwetenschappelijk onderzoek TNO, 2595 DA 's-Gravenhage (NL)
(72) Inventor: SEWAIT, Karl Everhardus, 2595 DA 's-Gravenhage (NL); KIERKS, Stan Anton Willem, 2595 DA 's-Gravenhage (NL); VAN PUT, Marloes Annet, 2595 DA 's-Gravenhage (NL)
(74) Representative: V.O.

(57) **Abstract**

The invention is directed to a photovoltaic roadway assembly, to a method of assembling the photovoltaic roadway assembly, and to a method of replacing one or more photovoltaic modules in the photovoltaic roadway assembly.

The photovoltaic roadway assembly of the invention comprises
a) a support with a convex surface having a curvature in a direction perpendicular to the driving direction of said roadway; and
b) one or more photovoltaic modules adapted for assembly with the support,
wherein said one or more photovoltaic modules are assembled to said support with two or more alignment profiles, said alignment profiles comprising mechanical releasable fixings for fastening the photovoltaic module to the support and straining the one or more photovoltaic modules over the convex surface of the support.

## Description

The invention is directed to a photovoltaic roadway assembly, to a method of assembling the photovoltaic roadway assembly, and to a method of replacing one or more photovoltaic modules in the photovoltaic roadway assembly.

Photovoltaic devices are well known in the art. Such devices absorb sunlight and convert it directly into useable electrical energy. A typical photovoltaic cell is a solid-state device in which a junction is formed between adjacent layers of semiconductor materials doped with specific atoms. When light energy or photons strike the semiconductor, electrons are dislodged from the valence band. These electrons, collected by the electric field at the junction, create a voltage that can be put at work in an external circuit. The basic principles that underlie this effect are well-known and understood to those skilled in the art.

While solar power generation is a clean method of generating energy, there remains a lack of a cohesive integrated infrastructure that uses solar energy as a power source. In addition, some customers find the appearance of solar panels on roofs unappealing and unattractive.

It would be desirable if solar power generation could be integrated in trafficable surfaces such as roads, parking lots, driveways, sidewalks and the like.

In recent years, photovoltaic trafficable surfaces have emerged as a solution to increase the amount of energy harvested from the sun. A photovoltaic trafficable surface known as SolaRoad® is located in the town of Krommenie in the Netherlands. This photovoltaic trafficable surface comprises a top layer of tempered glass of about 1 cm thick with underneath crystalline silicon solar cells. The SolaRoad® system is prefabricated as a whole as 2.5 by 3.5 metre concrete modules comprising the polycrystalline silicon solar cells. These modules have to be transported to the road site and placed as such on the desired location. It is not possible to replace only part of a concrete module upon failure. This rather inflexible construction method as well as inefficient maintenance requirement results in high costs per covered surface area and produced energy unit.

Another type of photovoltaic trafficable surface developed by Colas together with Commissariat à l'energie atomique et aux énergies alternatives is known as Wattway® and is, for instance, described in WO-A-2014/125415. In this system photovoltaic modules laminated on plastic (fibre reinforced polyester) flexible plates are glued on the existing paving and subsequently a continuous surfacing layer with is applied which has texturing elements that provide roughness. For cabling sleeves are milled in the paving that, after placing the cables are filled up and/or sealed. Non-destructive replacement of photovoltaic modules is hardly possible, if at all.

An integral concept of a traffic element with integrated photovoltaic module is described in WO-A-2005/086979. The integrated photovoltaic solar power system comprises a roadway panel with a solar energy collector and a layer of translucent and protective material, and an electrical conductor.

The existing photovoltaic roadway systems typically have the following components:
- a support
   Typically a plate or a block made from a material having high stiffness (such as concrete), which support functions as a base for the other components.
- a photovoltaic module
   Individual photovoltaic cells, that are interconnected into strings, which convert sunlight into electricity. The photovoltaic cells are laminated between layers of, for instance, plastic, glass and/or metal for protection against external mechanical and climatological influences.
- a top layer
   A rough, transparent top layer that allows the passage of sunlight and at the same time ensures a safe road surface for road users.
- an electrical system
   A system that ensures transport of the produced electricity to the desired location, such as to the electricity grid.

Different components of such a photovoltaic roadway system have a different life span. In particular, the photovoltaic modules, the top layer and some sub-components of the electrical system will probably degrade faster than the underlying support. This means that such components will need to be replaced faster. However, replacement and/or repair of individual components is hardly possible, if at all, in the existing photovoltaic roadway systems. It would thus be desirable to have a photovoltaic roadway assembly, which allows assembly and disassembly of separate components, in particular photovoltaic modules.

Objective of the invention is to address one or more disadvantages observed in the prior art.

The inventors found that this objective can, at least in part, be met by a photovoltaic roadway assembly wherein photovoltaic modules are fixed to a support in a specific manner.

Accordingly, in a first aspect the invention is directed to a photovoltaic roadway assembly, comprising
a) a support with a convex surface having a curvature in a direction perpendicular to the driving direction of said roadway; and
b) one or more photovoltaic modules adapted for assembly with the support,
wherein said one or more photovoltaic modules are assembled to said support with two or more alignment profiles, said alignment profiles comprising mechanical releasable fixings for fixing the photovoltaic module to the support and straining the one or more photovoltaic modules over the convex surface of the support.

Advantageously, the invention provides for a constructive design by means of a modular roadway system which allows replacement and repair of individual components. The design is such that the electrical system, the photovoltaic module including a top layer and the support can easily be individually manufactured, installed and replaced.

The support and the photovoltaic module may be separately produced and combined at a later point in time. They may, for example, be combined when preparing a pre-assembly for transport of elements to a road location, or they may be combined on the road location itself after placing the support. It is advantageous that the support and photovoltaic module can be produced, stored and transported separately, as both have different demands. For assembly of the photovoltaic modules, only mechanical, releasable, fixings are used, such as screw or clamp connections. No inseparable fixings are applied, such as those in the form of irreversible chemical curing connections (such as glues).

The invention advantageously allows relatively quick replacement of individual components, such as the photovoltaic module inclusive top layer, cabling, and electrical components (such as optimiser and converter). By replacing a photovoltaic module a damaged top layer can also be quickly fixed. The actual repair of a module or the top layer can take place in a production environment rather than on site. This means that the required duration of a road block is significantly shorter, and weather conditions, and curing times play a less important role.

The invention lengthens the overall life span of the photovoltaic roadway system, which promotes the exploitation thereof both from an economical as well as an environmental perspective. Furthermore, the assembly provides advantages during the production phase, because the production of the coarse support can take place separately from the production of the more delicate and technically complex production of the other (electronic) parts.

The support is preferably made of material having a high stiffness, such as concrete or brick. Preferably, the support is made of concrete. The support is suitably a construction base that serves to absorb most of the weight load of the traffic. Typically, for trafficable surfaces the weight load is in the range of 0.5-1.5 MPa. For the horizontal stability of the trafficable surfaces due to breaking forces a load in the range of 30-100 % of the weight load is taken into account.

The support suitably has a convex surface with a curvature in a direction perpendicular to the driving direction of the roadway, *viz.* a cross-section of the surface perpendicular to the driving direction has a convex profile bulging towards the driving surface of the roadway. This corresponds to a convex profile bulging towards the one or more photovoltaic modules to be assembled, such that the one or more photovoltaic modules are assembled in a convex manner onto the support. Hence, once installed the centre part of the assembly will be higher than the side parts of the assembly. A convex surface as defined herein corresponds to an surface that is arched or cruved (*viz.* a cross-section of the surface perpendicular to the driving direction is an arch or curve that that has a curvature in a direction towards the one or more photovoltaic modules. Preferably, the curvature can be a one dimensional curvature (*i*.*e*. curved solely in the direction perpendicular to the driving direction), but may also be a two-dimensional curvature. The highest point of the convex surface is typically at or near the middle of the support. The highest point of the convex surface may also be at one side of the support element while the lowest point is at the other side. In this way a wider road can be constructed by means of placing two elements side by side in such a way that the highest point is at or near the middle of the road. The convex surface also allows as a whole or partly for the required slope or inclination for drainage, typically for road constructions being in the range 2-4 % (1:50 to 1:25). The surface of the support may have a radius of curvature of 10-25 times the width of the support (or of the width of the roadway).

The support may suitably comprise recesses and/or sleeves for assembly of photovoltaic modules and electrical systems. Such electrical systems may include a junction box, connectors, wiring, cabling, *etc*.)

Extending along a direction perpendicular to the driving direction of the roadway, the support is preferably provided with one or more recesses for guiding cables of the one or more photovoltaic modules. These recesses can guide cables and/or wiring from the photovoltaic modules towards an optional cable tray, that is preferably present adjacent to the support, along the driving direction of the roadway. The cable tray may be a separate element along one side of the support or along both sides. Furthermore, one or two cable trays may be an integrated part of the support element (e.g. in-mould production). When two cable trays are applied in a road construction, cabling can cross over from one side of the road to the other via the recesses in the supports. Optionally, one or more recesses may comprises a lid, such as a lockable lid. The lid may be made of a material such as concrete, metal or plastic.

The photovoltaic modules may each comprise a junction box at the bottom side (*i*.*e*. the side to be assembled with the support), which may be close to the edge. Preferably, the location of the junction boxes and the assembly with the support is such that the junction boxes are positioned above the recess of the support that extends along the direction perpendicular to the driving direction of the roadway. This suitably allows to guide connection wires of the junction box into the recesses and further to the cable tray. Alternatively, the location of the junction boxes and the assembly with the support may be such that the junction boxes are positioned above the one or more recesses for assembling one or more photovoltaic modules.

The support may comprise one or more further jacket pipes for other cables.

The one or more recesses may comprise sleeves, slits, and/or profiles (metal profiles, aluminium profiles, or plastic extrusion profiles). These sleeves and/or profiles may aid in supporting the photovoltaic modules. The support may further comprise one or more jacket pipes within the support that may be used for cabling. In that case, recesses should be provided with space for junction box and openings for inserting the cables in the jacket pipe. For this purpose, the jacket pipe itself may have openings, or openings can be made upon assembly.

Each photovoltaic module typically comprises a photovoltaic panel consisting of a plurality of photovoltaic cells, being polycrystalline silicon solar cells or thin film solar cells, e.g. amorphous silicon (a-Si), cadmium telluride (CdTe), copper indium gallium selenide (CIGS) or organic PV (OPV). Polycrystalline silicon solar cells commonly each have a dimension of 156 × 156 mm, and a panel commonly consists of typically 6 × 10 cells and has a dimension of about 1000 × 1600 mm. Thin film solar cells and panels on the other hand may vary in sizes and dimensions. Optionally, one or more layers of separation foil and/or top foil may be applied in the photovoltaic module manufacturing process so as to prepare a more robust photovoltaic module.

The separation foil typically comprises ethylene-vinyl-acetate, polyvinylbutyral and/or polyolefin. The top foil typically comprises ethylene-tetrafluoroethylene, polyethylene terephthalate, polycarbonate and/or glass,.

The photovoltaic module may optionally be provided with edges of a material that provides the photovoltaic module with additional mechanical strength. This can be advantageous for handling, transport and protection. Furthermore, in use such edges may provide additional protection against water penetration and mechanical edge protection against traffic load.

Hence, each photovoltaic module has its own integrated top layer comprising one or more impact layers and/or wear layers. In case of a defective photovoltaic module or a defective top layer, repair thus requires replacement of a photovoltaic module inclusive top layer. The defective photovoltaic module may be repaired in a production environment rather than on site.

The support has a convex surface having a curvature perpendicular to the driving direction of said roadway. The one or more photovoltaic modules are assembled to the support with two or more alignment profiles. The two or more alignment profiles may be attached to the photovoltaic modules, typically at a side opposite to the light incident side thereof. It is also possible that they are attached to the support at a side that is to be assembled with the one or more photovoltaic modules. Another possibility is to employ loose alignment profiles that are subsequently fixed to both the one or more photovoltaic modules as well as to the support. The alignment profiles may suitably have the form of a shaft. These alignment profiles may preferably be glued underneath (viz. the side opposite to the light incident side thereof) the photovoltaic modules. The alignment profiles are provided with mechanical releasable fixings for fixing the photovoltaic module to the support. Suitably, a photovoltaic module comprises two alignment profiles at two opposite sides or edges of the photovoltaic module, preferably the sides or edges that run along the driving direction of the roadway. The mechanical releasable fixings are used to strain or stretch the one or more photovoltaic modules over the convex surface of the support, such that the one or more photovoltaic modules are assembled in a convex manner to the support.

The mechanical releasable fixings allow for fixing the photovoltaic module to the support and straining the one or more photovoltaic modules over the two-dimensionally curved surface of the support. Suitably, the support is provided with metallic sleeves along the side edges thereof for receiving the mechanical releasable fixings on the alignment profiles of the one or more photovoltaic modules. The metallic sleeves may have a V-shape or a U-shape in which the mechanical releasable fixings may be fixed.

The mechanical releasable fixings may, for example, comprise locking pens (such as stifts, screws, and/or bolts) and straining fixings (such as a threaded sleeve or a nut in combination with a bolt, a locking screw, a retaining screw, or a jack bolt). Suitably, a photovoltaic module comprises both a locking pen as well as a straining fixing. The photovoltaic module can then typically be fixed to the support at one side with a locking pen. Subsequently, the relatively flexible photovoltaic module may be strained over the curved surface of the support and fixed at the other side by means of the straining fixing. It is also possibly that the mechanical releasable fixings comprise straining fixings at both sides of the photovoltaic module, such that the module is fixed to the support at both sides with straining fixings.

When the one or more photovoltaic modules are strained over the curved surface of the support and fixed, the required compressive stress is preferably distributed as even as possible over the entire surface. This may be realised by an optional pressure layer that may be present between the support and the one or more photovoltaic modules. The pressure layer may ensure a reasonably equal pressure, concentric to the curvature of the support.

Additionally, straining and fixing the one or more photovoltaic modules over the curved surface of the support is suitably performed by combining a downward movement of the photovoltaic module with a sideways movement, *viz*. stretching. For this purpose, the employed straining force is directed towards the centre of the curvature, as well as sideways (touching the curvature). The resulting straining force therefore suitably has an angle between 0° and 45°, wherein 0° corresponds to the horizontal plane parallel to the roadway and 90° corresponds to the vertical plane, perpendicular to the roadway.

Therefore, in a preferred embodiment the mechanical releasable fixings are positioned in the assembly at an angle between 0° and 45°, wherein 0° corresponds to the horizontal plane parallel to the roadway and 90° corresponds to the vertical directing downwards, perpendicular to the roadway.

The straining fixings may also comprise a spring system to provide and maintain a constant strain on the photovoltaic module. Such a spring system may optionally be combined with the above-mentioned locking pens and straining fixings.

According to a first option, a spring system comprises one or more compression strings. A compression spring typically comprises a spring in a sleeve, such as a metal sleeve. Such compressing spring system is preferably combined with straining fixings, such as a locking screw, a retaining screw, or a jack bolt. Such a combination advantageously allows to set the applied pressure or strain and/or adjust the applied pressure or strain after a period of time.

In a further option, a spring system comprises one or more cup springs. The use of cup springs has the advantages of requiring less space in comparison to the option of using compression springs.

In a preferred embodiment, the spring system comprises one or more adjustable compression springs and/or cup springs.

For example, the alignment profiles may be provided with a sleeve having a female thread and a spring (such as a compression spring or a cup spring). In the sleeve, a plug or screw having a male thread is provided, which plug or screw can be fastened and released. By fastening the plug or screw, the spring is tightened between the plug or screw and the receiving sleeve.

The convex surface in combination with the strained photovoltaic module ensure sufficient permanent contact between the photovoltaic module and the support surface. This may be further aided by an optional intermediate removable pressure layer between the support and the photovoltaic module. The pressure layer serves to absorb irregularities at the support surface, to prevent peak tensions on the thin back sheet and to maintain the photovoltaic module under the required strain such that undesirable movements and deformations (such as bulging, loosening and flapping) caused by thermal expansion and mechanical loads are absorbed and/or prevented.

The pressure layer may be a semi-finished product of a closed or semi-closed cell rubber, a closed or semi-closed cell foam, and/or a thermoplastic elastomer. Examples of closed and semi-closed cell rubbers include ethylene-propylene-diene-monomer rubber and nitrilbutadiene rubber. Examples of closed and semi-closed cell foams include polyethylene foam, and polyurethane foam. Furthermore, the pressure layer may be a semi-finished product of an open, porous structure for purposes of water and moisture regulation. Suitably, the pressure layer has sufficient thickness, stiffness, and modulus to absorb the movements and deformations. The semi-finished product can be cut to the right dimensions and can be applied loose between the photovoltaic module and the support upon assembly, or can be applied on the photovoltaic module in self-adhesive form.

The pressure layer may have a thickness in the range of 0.5-20 mm, such as in the range of 5-10 mm. The pressure layer has to ensure sufficient friction between the photovoltaic module and the layer and between the layer itself and the concrete support. For a rubber material and a steel back sheet of the photovoltaic module the static coefficient of friction is typically in the range 1.0-1.4. The static coefficient of friction for the combination for rubber and dry concrete is typically in the range 0.6-1.0.

The convex surface of the support has a defined surface roughness to ensure sufficient friction between the photovoltaic module and the support. This allows for forces in the (mainly) horizontal plane (such as those caused by breaking or turning of vehicles) to be transferred to the ground. If the surface roughness is too high, this may lead to locally increased tensions in the photovoltaic modules. Accordingly, the two-dimensionally curved surface of the support has a surface roughness expressed as a dynamic coefficient of friction typically in the range between 0.5-1, when measured with a Floor Slide Control 2000 according to NTA 7909:2003.

In order to realise sufficient friction between the photovoltaic module and the support, the geometry of the surface of the support may suitably comprise a macrotexture, a microtexture, or both combined. A macrotexture can give mechanical locking, while a microtexture can ensure sufficient friction at the contact surfaces.

Macrotexturing may, for instance, be realised by brushing a freshly prepared support, such as a freshly prepared concrete support, in a direction transverse to the driving direction of the roadway. It is also possible to employ structuring mats during the moulding process so as to provide macrotexturing and/or microstructuring during production of prefabrication support elements.

The photovoltaic roadway assembly may further comprise one or more cable trays along the driving direction of said roadway. The one or more cable trays may either be integrated in the support or may be provided as a separate element. The cable tray may suitably provide space for electrical components, such as cabling, optimisers, and converters. The cable tray suitably comprises a lid, preferably a lockable lid. The lid may be made of a material such as concrete, metal or plastic. The lid extends along the driving direction of the roadway.

Cables or wiring of the photovoltaic modules that run through recesses and/or sleeves perpendicular to the driving direction lead to the cable tray.

Opening the cable tray (which is preferably positioned in driving direction adjacent to an assembly of support and photovoltaic modules) by removal of the lid preferably makes accessible the mechanical releasable fixings of the photovoltaic modules that are preferably assembled directly adjacent the cable tray. After installation and locking of the cable tray, the mechanical releasable fixings for the photovoltaic modules are no longer visible and accessible for unauthorised persons.

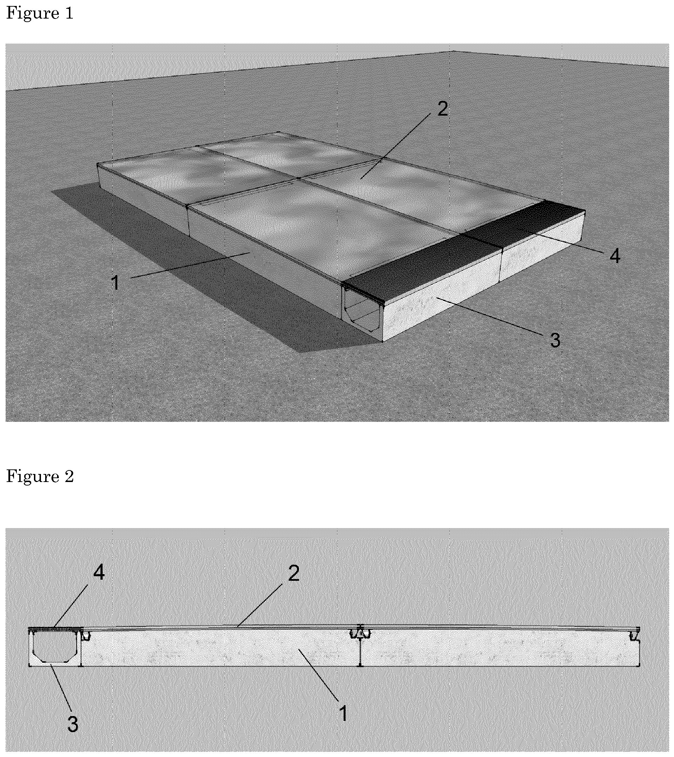

A schematic example of a photovoltaic roadway assembly of the invention is shown in figure 1. This photovoltaic roadway assembly comprises a support 1, four (2 × 2) photovoltaic modules 2 (each typically having a dimension of 1000 × 1600 mm). While the exemplary assembly shown in figure 1 has four photovoltaic modules, it is for instance also possible to use one (1 × 1), two (1 × 2), six (2 × 3), or more photovoltaic modules. Furthermore, figure 1 shows a cable tray 3 with a lockable lid 4. A cross section of the photovoltaic roadway assembly of figure 1 is shown in figure 2.

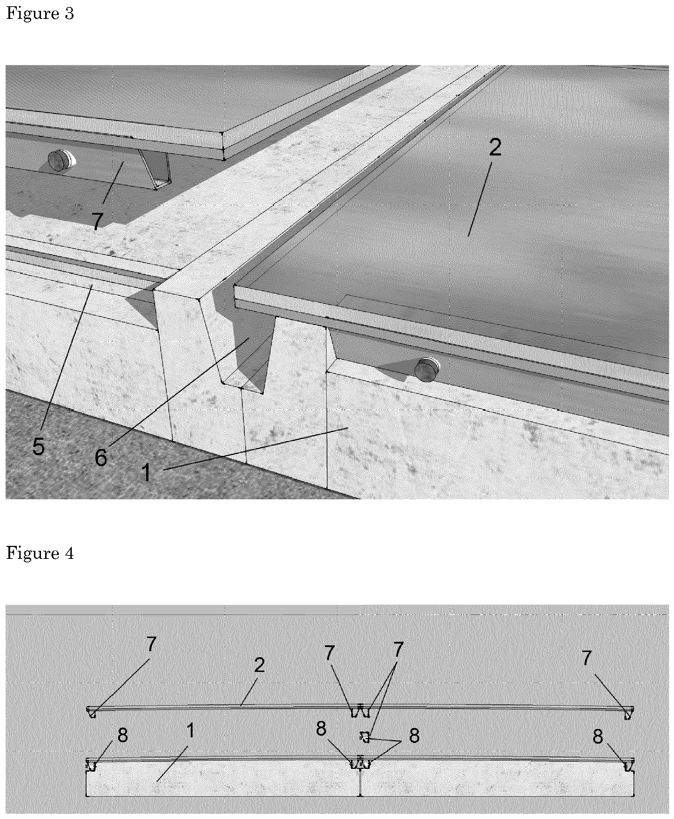

Figure 3 shows recesses that are provided in support 1. As shown in figure 3, support 1 has recesses 5 for assembling one or more photovoltaic modules 2. Support 1 additionally has recesses 6 that extend along a direction perpendicular to the driving direction of said roadway and which may be used for guiding cables of the one or more photovoltaic modules 2. Also shown in figure 3 is alignment profile 7 that is attached on the bottom of a photovoltaic module 2.

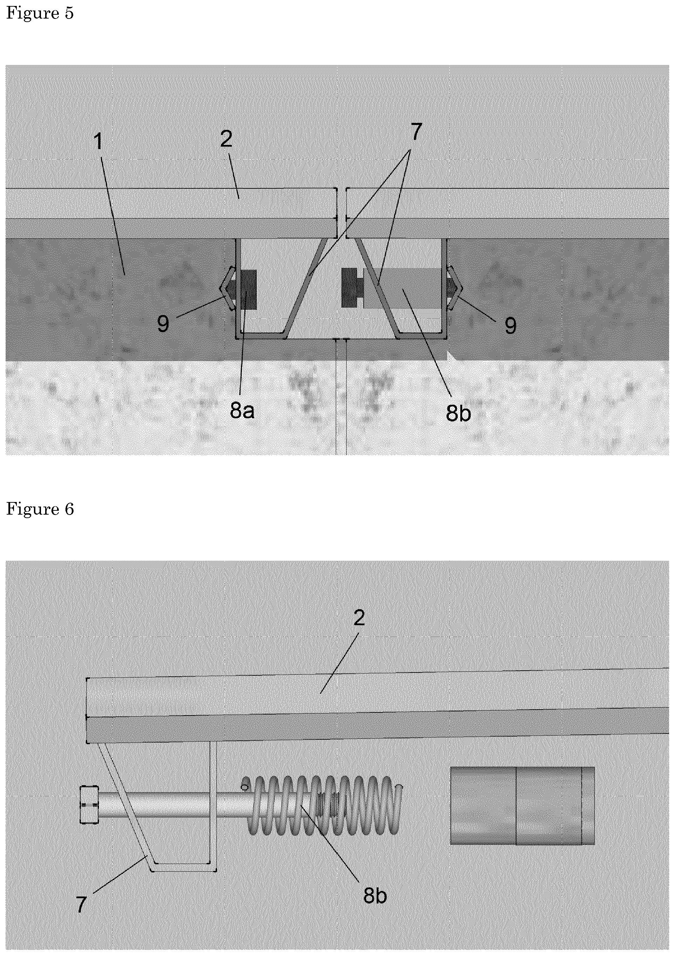

Figure 4 shows how photovoltaic modules 2 can be assembled to on support 1 using alignment profiles 7 and mechanical releasable fixings 8 that are comprised on alignment profiles 7. This is shown in more detail in figure 5. Similar to figure 4, figure 5 shows how photovoltaic modules 2 are assembled on support 1 using alignment profiles 7 and mechanical releasable fixings 8 that are comprised on alignment profiles 7. In figure 5, mechanical releasable fixings 8 comprise a locking pen 8a (in the example of figure 5 shown as a bolt) and a straining fixing 8b (in the example of figure 5 shown as a threaded sleeve in combination with a bolt). Also shown in figure 5, are metallic sleeves 9 that are provided along the side edges of support 1 and which receive the mechanical releasable fixings 8 on alignment profiles 7 of photovoltaic modules 2.

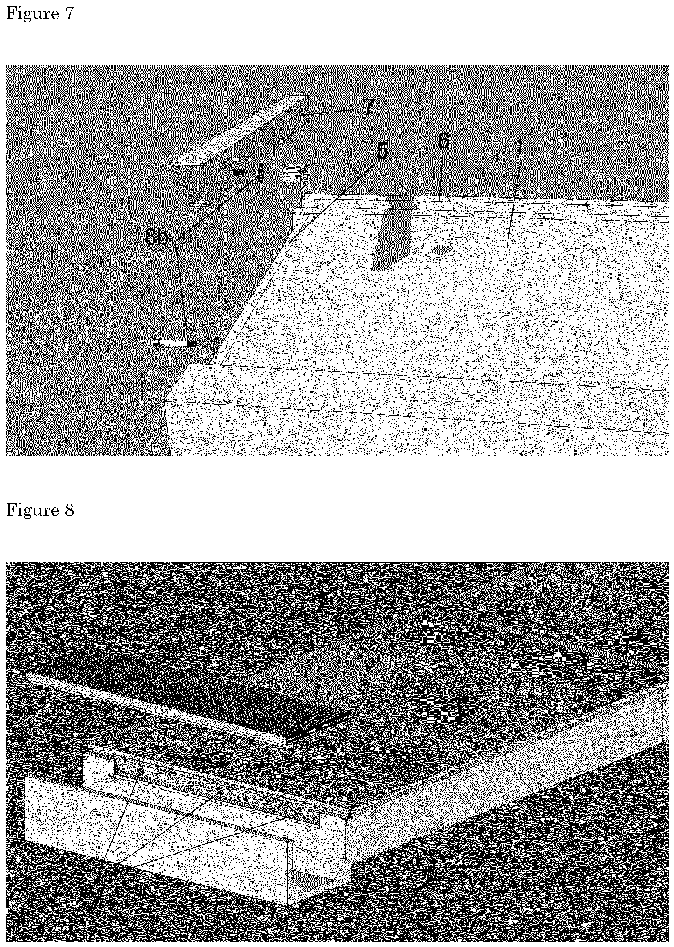

An embodiment with a spring system is shown in figure 6. The exemplary embodiment of figure 6 shows photovoltaic module 2 with alignment profile 7 and straining fixing 8b that comprises a bolt, a compression spring, and a threaded sleeve. Another embodiment with a spring system is shown in figure 7. This figure shows support 1 with recess 5 along the driving direction of the roadway and recess 6 for assembling the photovoltaic modules with alignment profile 7 and straining fixing 8b that comprises a bolt, a cup spring, and a threaded sleeve.

Figure 8 shows photovoltaic module 2 assembled with support 1 together with cable tray 3 along the driving direction of the roadway and lockable lid 4. In figure 8, lockable lid 4 has been lifted to allow access to mechanical releasable fixings 8 that are provided on alignment profile 7.

The invention is further directed to a method of assembling a photovoltaic roadway assembly according to the invention, comprising
i) providing the support,
ii) optionally placing one or more cable trays adjacent to the support along the driving direction of the roadway,
iii) optionally placing a pressure layer onto said support,
iv) assembling the one or more photovoltaic modules onto the support such that the optional pressure layer is between the support and the one or more photovoltaic modules, wherein at least part of the mechanical releasable fixings are fixed, preferably via access of the one or more optional cable trays and/or one or more recesses in the support, and
v) optionally closing the one or more optional cable trays and/or one or more recesses in the support using a lid.

In operation, typically first the support will be placed on site. However, it is also possible to assemble the assembly off site and place the whole assembly at once on site. The support may suitably be composed of multiple support elements that can be combined. It is possible to use couplings for linking the different support elements. Such couplings can prevent vertical movements between different support elements because this may lead to reduction of road comfort and, eventually, to possible dangerous situations. Rotation between different support elements should be possible in order to absorb settings in the ground.

One or more cable trays may be placed adjacent to the support along the driving direction of the roadway. For example, a single cable tray may be placed along one side of the roadway, or two cable trays may be placed, i.e. one on each side of the roadway. The cable tray may initially be placed without the optionally lockable lid. This lid can be mounted once the assembly has been installed.

A pressure layer may then be applied onto the support, either separately, or together with the one or more photovoltaic modules. Typically, the pressure layer has holes that allow electronic components to pass through (such as cables, wires, optimisers, converters, and the like).

The support is assembled with the one or more photovoltaic modules. The alignment profiles may be used to correctly position the photovoltaic modules. Once the photovoltaic module is correctly positioned, it may be fixed by tightening the mechanical releasable fixings on the alignment profiles that are accessible via the cable tray. Typically, the photovoltaic module is mechanically snapped to the support on one side and strained or stretched over the two-dimensionally curved surface of the support on the other using straining fixings.

After installation of the one or more photovoltaic modules, the cable tray may be closed using the lid, thereby removing the mechanical releasable fixings from sight, and is preferably locked by using a lockable lid.

Disassembly of the photovoltaic roadway assembly may be performed in reversed order. Hence, a method of disassembling a photovoltaic roadway assembly according to the invention, comprises
i) optionally opening one or more optional cable trays and/or one or more recesses in the support by removing a lid,
ii) disassembling the one or more photovoltaic modules from the support by unfixing mechanical releasable fixings, preferably via access of one or more optional cable trays and/or one or more recesses in the support, and
iii) optionally removing a pressure layer from said support,
iv) optionally removing one or more cable trays adjacent to the support along the driving direction of the roadway,
v) removing the support.

In a further aspect, the invention is directed to a method of replacing one or more photovoltaic modules in a photovoltaic roadway assembly according to the invention, comprising
i) unfixing the mechanical releasable fixings and replacing at least part of the one or more photovoltaic modules with one or more fresh photovoltaic modules as described herein, and
ii) fixing the mechanical releasable fixings,
wherein at least part of said mechanical releasable fixings are preferably accessed via one or more cable trays and/or one or more recesses in the support.

Accessing the mechanical releasable fixings via one or more cable trays and/or one or more recesses in the support may first require removing a lid from the said one or more cable trays and/or recesses. In case of a lockable lid, the lid first needs to be unlocked. After having fixed the mechanical releasable fixings, the lid of the one or more cable trays and/or recesses may be replaced, and optionally locked.

Upon damage or defect of a photovoltaic module, or a top layer thereof, one or more photovoltaic modules may be replaced by optionally removing the lid may be removed to gain access to at least part of the mechanical releasable fixings. Unfixing sufficient mechanical releasable fixings allows the removal of one or more photovoltaic modules, after which one or more fresh (*i*.*e*. non-damaged) similar photovoltaic modules may be assembled to the support by fixing sufficient mechanical releasable fixings, preferably via access of the one or more cable trays. Once, the required amount of photovoltaic modules has been replaced, the optionally lockable lid of the cable trays may be replaced and locked if necessary.

The invention has been described by reference to various embodiments, compositions and methods. The skilled person understands that features of various embodiments, compositions and methods can be combined with each other.

All references cited herein are hereby completely incorporated by reference to the same extent as if each reference were individually and specifically indicated to be incorporated by reference and were set forth in its entirety herein.

The use of the terms "a" and "an" and "the" and similar referents in the context of describing the invention (especially in the context of the claims) are to be construed to cover both the singular and the plural, unless otherwise indicated herein or clearly contradicted by context. The terms "comprising", "having", "including" and "containing" are to be construed as open-ended terms (*i*.*e*., meaning "including, but not limited to") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention. For the purpose of the description and of the appended claims, except where otherwise indicated, all numbers expressing amounts, quantities, percentages, and so forth, are to be understood as being modified in all instances by the term "about". Also, all ranges include any combination of the maximum and minimum points disclosed and include any intermediate ranges therein, which may or may not be specifically enumerated herein.

Preferred embodiments of this invention are described herein. Variation of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject-matter recited in the claims appended hereto as permitted by applicable law. Moreover, any combination of the above-described elements in all possible variations thereof is encompassed by the invention unless otherwise indicated herein or otherwise clearly contradicted by context. The claims are to be construed to include alternative embodiments to the extent permitted by the prior art.

For the purpose of clarity and a concise description features are described herein as part of the same or separate embodiments, however, it will be appreciated that the scope of the invention may include embodiments having combinations of all or some of the features described.

## Claims

1. Photovoltaic roadway assembly, comprising
a) a support with a convex surface having a curvature in a direction perpendicular to the driving direction of said roadway;
b) one or more photovoltaic modules adapted for assembly with the support,
wherein said one or more photovoltaic modules are assembled to said support with two or more alignment profiles, said alignment profiles comprising mechanical releasable fixings for fastening the photovoltaic module to the support and straining the one or more photovoltaic modules over the convex surface of the support.

2. Photovoltaic roadway assembly according to claim 1, wherein the alignment profiles are provided at two opposite sides of the photovoltaic module.

3. Photovoltaic roadway assembly according to claim 1 or 2, wherein the support comprises metallic sleeves along the side edges thereof for receiving the mechanical releasable fixings on the alignment profiles of the one or more photovoltaic modules.

4. Photovoltaic roadway assembly according to any one of claims 1-3, wherein the mechanical releasable fixings comprise at least one locking pen and at least one straining pen at opposite sides of the photovoltaic module.

5. Photovoltaic roadway assembly according to any one of claims 1-4, wherein the mechanical releasable fixings are positioned in the assembly at an angle between 0° and 45°, wherein 0° corresponds to the horizontal plane parallel to the roadway and 90° corresponds to the vertical direction downwards, perpendicular to the roadway.

6. Photovoltaic roadway assembly according to any one of claims 1-5, wherein the mechanical releasable fixings comprise one or more compression springs or cup springs, preferably one or more adjustable compression springs or cup strings..

7. Photovoltaic roadway assembly according to any one of claims 1-6, wherein said support comprises one or more recesses for assembling one or more photovoltaic modules, wherein said one or more recesses preferably comprise a slit or profile in the support.

8. Photovoltaic roadway assembly according to any one of claims 1-7, further comprising:
c) a pressure layer between said support and said one or more photovoltaic modules, said pressure layer preferably comprising one or more selected from a closed or semi-closed cell rubber, a closed or semi-closed cell foam and a thermoplastic elastomer, and wherein said pressure layer preferably has a thickness in the range of 0.5-20 mm.

9. Photovoltaic roadway assembly according to claim 8, wherein said pressure layer is a semi-finished product of an open, porous structure.

10. Photovoltaic roadway assembly according to any one of claims 1-9, further comprising:
d) one or more cable trays along the driving direction of said roadway comprising space for cabling and electric components, wherein said one or more cable trays comprise a lid, preferably a lockable lid, and wherein removal of the lid allows access to at least part of the said mechanical releasable fixings

11. Photovoltaic roadway assembly according to any one of claims 1-10, wherein the support comprises one or more recesses or sleeves for cabling, wherein said one or more recesses or sleeves preferably extend along a direction perpendicular to the driving direction of said roadway, and wherein said cabling preferably is cabling for the one or more photovoltaic modules.

12. Photovoltaic roadway assembly according to any one of claims 1-11, wherein the one or more photovoltaic modules have a thickness in the range of 3-10 mm, preferably, 4-8 mm, such as 5-7 mm.

13. Photovoltaic roadway assembly according to any one of claims 1-12, wherein the convex surface of the support has a surface roughness expressed as a dynamic coefficient of friction in the range between 0.5-1, when measured with a Floor Slide Control 2000 according to NTA 7909:2003.

14. A method of assembling a photovoltaic roadway assembly according to any one of claims 1-13, comprising
i) providing the support,
ii) optionally placing one or more cable trays adjacent to the support along the driving direction of the roadway,
iii) optionally placing a pressure layer onto said support,
iv) assembling the one or more photovoltaic modules onto the support such that the optional pressure layer is between the support and the one or more photovoltaic modules, wherein at least part of the mechanical releasable fixings are fixed preferably via access of the one or more optional cable trays and/or one or more recesses in the support, and
v) optionally closing the one or more optional cable trays and/or one or more recesses in the support using a lid.

15. A method of replacing one or more photovoltaic modules in a photovoltaic roadway assembly according to any one of claims 1-13, comprising
i) releasing the mechanical releasable fixings and replacing at least part of the one or more photovoltaic modules with one or more fresh photovoltaic modules as defined in any one of claims 1, 2, 4, 5 and 11,
ii) fastening the mechanical releasable fixings,
wherein at least part of said mechanical releasable fixings are preferably accessed via one or more cable trays and/or one or more recesses in the support.
